(19) **Europäisches Patentamt / European Patent Office / Office européen des brevets**

(11) **EP 3 965 297 B1**

(12) **EUROPEAN PATENT SPECIFICATION**

(45) Date of publication and mention of the grant of the patent:
**08.11.2023 Bulletin 2023/45**

(21) Application number: **20910265.6**

(22) Date of filing: **29.09.2020**

(51) International Patent Classification (IPC):
**H03K 17/04** (2006.01)   **H03K 17/26** (2006.01)

(52) Cooperative Patent Classification (CPC):
**H03K 17/10; H03K 17/12; H03K 17/26;**
H03K 17/102; H03K 17/107; H03K 17/122;
H03K 17/127

(86) International application number:
**PCT/CN2020/118807**

(87) International publication number:
**WO 2021/135465 (08.07.2021 Gazette 2021/27)**

(54) **CONTROL METHOD AND CONTROL APPARATUS FOR SWITCHING APPARATUS**

STEUERVERFAHREN UND STEUERVORRICHTUNG FÜR EIN SCHALTGERÄT

PROCÉDÉ DE COMMANDE ET APPAREIL DE COMMANDE POUR APPAREIL COMMUTATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.12.2019   CN 201911397900**

(43) Date of publication of application:
**09.03.2022   Bulletin 2022/10**

(73) Proprietor: **Huawei Digital Power Technologies Co., Ltd.**
**Shenzhen, Guangdong 518043 (CN)**

(72) Inventors:
• **WANG, Xudong**
**Shenzhen, Guangdong 518129 (CN)**

• **WANG, Zhaohui**
**Shenzhen, Guangdong 518129 (CN)**
• **SHI, Lei**
**Shenzhen, Guangdong 518129 (CN)**

(74) Representative: **Gill Jennings & Every LLP**
**The Broadgate Tower**
**20 Primrose Street**
**London EC2A 2ES (GB)**

(56) References cited:
WO-A2-2006/096781      CN-A- 104 348 340
CN-A- 107 800 277      CN-A- 108 111 004
CN-A- 108 736 703      CN-A- 111 130 514
US-A1- 2013 257 177      US-A1- 2016 204 775

## Description

This application claims priority to Chinese Patent Application No. 201911397900.3, filed with the China National Intellectual Property Administration on December 30, 2019 and entitled "CONTROL METHOD AND CONTROL APPARATUS FOR SWITCHING APPARATUS".

## TECHNICAL FIELD

This application relates to a switching apparatus, and in particular, to a control method and a control apparatus for a switching apparatus.

## BACKGROUND

A switching apparatus may include at least two switching devices connected in parallel. When the at least two switching devices are simultaneously turned on, an on-resistance of the switching apparatus may be reduced, thereby reducing a loss of the switching apparatus. Switching losses of the two switching devices are different. The two switching devices are separately controlled, so that the switching device with a relatively high switching loss implements zero voltage switching, and the loss of the switch apparatus can be further reduced. However, due to influence of a switching speed of the switching device, when an on-state holding time of the switching apparatus is relatively short, a switching failure may occur in all or some of the switching devices in the switching apparatus.

For switching devices, a minimum pulse width limit is set based on a switching speed of the switching device. When the on-state holding time of the switching device is less than the minimum pulse width limit, and when a control signal that uses the on-state holding time as a pulse width controls the switching device, the switching device cannot be effectively turned on or off, and output distortion occurs. Therefore, the switching device can be controlled not to perform a switching operation, and can be controlled to remain in a turn-on or cut-off state. When the on-state holding time of the switching device is greater than or equal to the minimum pulse width limit, the switching device is controlled to perform the switching operation, so as to control current connection or disconnection.

The switching apparatus includes a plurality of switching devices. When the on-state holding time is relatively short, the output distortion may occur due to the minimum pulse width limit. Improper switching control mode may cause a relatively large output distortion of the switching apparatus.
US 2013/0257177 A1 discloses an adaptive gate control method and circuit for composite power switch.

## SUMMARY

This application provides a control method and a control apparatus for a switching apparatus, to reduce output distortion while reducing a loss.

According to a first aspect, a control method for a switching apparatus to reduce output distortion while reducing a loss is provided. The switching apparatus includes at least two switching devices connected in parallel, and among the at least two switching devices, a minimum pulse width limit of a first switching device is less than a minimum pulse width limit of a second switching device. The method includes: obtaining an on-state holding time of the switching apparatus; controlling, when the on-state holding time is less than the minimum pulse width limit of the first switching device, the at least two switching devices to remain in a cut-off state; and controlling, when the on-state holding time is greater than or equal to the minimum pulse width limit of the first switching device, the first switching device to perform a switching operation.

When the on-state holding time is less than the minimum pulse width limit of the first switching device, the first switching device is controlled to be cut off, and when the on-state holding time is greater than or equal to the minimum pulse width limit of the first switching device, the first switching device is controlled to perform the switching operation, to reduce a loss of the switching apparatus and reduce output distortion.

The second switching device may be any one of the at least two switching devices. Among the at least two switching devices, the first switching device has a minimum value of the minimum pulse width limit.

With reference to the first aspect, the method further includes: controlling, when the on-state holding time is less than the minimum pulse width limit of the second switching device, the second switching device to remain in a cut-off state; and controlling, when the on-state holding time is greater than or equal to the minimum pulse width limit of the second switching device, the first switching device and the second switching device to perform switching operations.

Based on a value relationship between the minimum pulse width limit of the second switching device and the on-state holding time, the second switching device is controlled to be turned on and off, thereby further reducing the loss of the switching apparatus.

With reference to the first aspect, in some possible implementations, the controlling, when the on-state holding time is greater than or equal to the minimum pulse width limit of the second switching device, the first switching device and the second switching device to perform switching operations includes: generating a first control signal of the first switching device and a second control signal of the second switching device, where when the first switching device and the second switching device are turned on, a time point at which the first control signal flips is not later than a time point at which the second control signal flips.

Compared with the second switching device, the first switching device has a shorter turn-on time and a smaller switching loss. The first switching device is controlled to be on no later than the second switching device, so that the first switching device bears a main turn-on loss to reduce the loss of the switching apparatus.

A control signal flipping means that a level of the control signal changes from a high level to a low level or from a low level to a high level. In other words, a voltage of the control signal changes. A time point at which the control signal flips may be a time point at which the control signal reaches a preset value. In a turn-on process of the switching device, a time point at which the control signal reaches a preset turn-on value is a time point at which the control signal flips. In a turn-off process of the switching device, a time point at which the control signal reaches a preset turn-off value is a time point at which the control signal flips.

With reference to the first aspect, in some possible implementations, the controlling, when the on-state holding time is greater than or equal to the minimum pulse width limit of the second switching device, the first switching device and the second switching device to perform switching operations includes: generating a first control signal of the first switching device and a second control signal of the second switching device, where when the first switching device and the second switching device are turned off, a time point at which the first control signal flips is later than a time point at which the second control signal flips.

Compared with the second switching device, the first switching device has a shorter turn-off time and a smaller switching loss. The first switching device is controlled to be turned off later than the second switching device, so that the first switching device can bear a main turn-off loss to reduce the loss of the switching apparatus.

With reference to the first aspect, in some possible implementations, a material of the first switching device is a wide-bandgap semiconductor material, and a material of the second switching device is a silicon material.

With reference to the first aspect, in some possible implementations, the at least two switching devices are power semiconductor devices.

A power device is configured to process a large voltage and a large current, and a power consumption problem of the power device is more serious. The power device is controlled to effectively resolve the power consumption problem of the power device.

With reference to the first aspect, in some possible implementations, the minimum pulse width limit of the first switching device is determined based on a turn-on time of the first switching device and/or a turn-off time of the first switching device.

According to a second aspect, a control apparatus for a switching apparatus to reduce output distortion while reducing a loss is provided. The switching apparatus includes at least two switching devices connected in parallel, a minimum pulse width limit of a first switching device of the at least two switching devices is less than a minimum pulse width limit of a second switching device of the at least two switching devices. The apparatus includes: an obtaining module, configured to obtain an on-state holding time of the switching apparatus; and a control module, configured to: control, when the on-state holding time is less than the minimum pulse width limit of the first switching device, the at least two switching devices to remain in a cut-off state; and control, when the on-state holding time is greater than or equal to the minimum pulse width limit of the first switching device, the first switching device to perform a switching operation.

With reference to the second aspect, the control module is further configured to: control, when the on-state holding time is less than the minimum pulse width limit of the second switching device, the second switching device to remain in a cut-off state; and control, when the on-state holding time is greater than or equal to the minimum pulse width limit of the second switching device, the first switching device and the second switching device to perform switching operations.

With reference to the second aspect, in some possible implementations, the control module is configured to generate a first control signal of the first switching device and a second control signal of the second switching device, where when the first switching device and the second switching device are turned on, a time point at which the first control signal flips is not later than a time point at which the second control signal flips.

With reference to the second aspect, in some possible implementations, the control module is configured to generate a first control signal of the first switching device and a second control signal of the second switching device, where when the first switching device and the second switching device are turned off, a time point at which the first control signal flips is later than a time point at which the second control signal flips.

With reference to the second aspect, in some possible implementations, a material of the first switching apparatus is a wide-bandgap semiconductor material, and a material of the second switching apparatus is a silicon material.

With reference to the second aspect, in some possible implementations, the at least two switching devices are power semiconductor devices.

With reference to the second aspect, in some possible implementations, among the at least two switching devices, the first switching device has a minimum value of the minimum pulse width limit.

With reference to the second aspect, in some possible implementations, the minimum pulse width limit of the first switching device is determined based on a turn-on time of the first switching device and/or a turn-off time of the first switching device.

According to a third aspect, a control apparatus for a switching apparatus is provided, including a memory and a processor. The memory is configured to store a program, and when the program is executed in the control apparatus, the processor is configured to perform the method according to the first aspect.

According to a fourth aspect, a computer storage medium is provided. The computer storage medium stores computer instructions, and when the computer instructions are run on an electronic device, the electronic device is enabled to perform the method according to the first aspect.

According to a fifth aspect, a chip system is provided. The chip system includes at least one processor, and when program instructions are executed in the at least one processor, the chip system is enabled to perform the method according to the first aspect.

According to a sixth aspect, a switchgear is provided, including a switching apparatus and the control apparatus for a switching apparatus according to the second aspect or the third aspect.

**BRIEF DESCRIPTION OF DRAWINGS**

FIG. 1 is a turn-on and turn-off waveform diagram of an insulated gate bipolar transistor;
FIG. 2 is a schematic diagram of a series type hybrid power device;
FIG. 3 is a turn-on and turn-off waveform diagram of the series type hybrid power device;
FIG. 4 is a schematic diagram of a parallel type hybrid power device;
FIG. 5 is a turn-on and turn-off waveform diagram of the parallel type hybrid power device;
FIG. 6 is a schematic flowchart of a control method for a switching apparatus according to an embodiment of this application;
FIG. 7 is a schematic flowchart of another control method for a switching apparatus according to an embodiment of this application;
FIG. 8 is a waveform diagram of a control signal according to an embodiment of this application;
FIG. 9 is a waveform diagram of another control signal according to an embodiment of this application;
FIG. 10 is a schematic structural diagram of a switchgear according to an embodiment of this application;
FIG. 11 is a schematic structural diagram of a control apparatus for a switching apparatus according to an embodiment of this application; and
FIG. 12 is a schematic structural diagram of another control apparatus for a switching apparatus according to an embodiment of this application.

**DESCRIPTION OF EMBODIMENTS**

The following describes technical solutions of this application with reference to accompanying drawings.

A power electronic device (power electronic device), also referred to as a power semiconductor device, may be used in aspects such as electric energy conversion and a control circuit of a power device, and is a semiconductor device having a capability of processing a high voltage and a large current.

A fully-controlled device, also referred to as a self-turn-off device, refers to a power electronic device that can be controlled to be turned on and off by using a control signal.

Common fully-controlled voltage-driven power semiconductor devices include an insulated gate bipolar transistor (insulated gate bipolar transistor, IGBT), a metal oxide semiconductor field effect transistor (metal oxide semiconductor field effect transistor, MOSFET), an integrated gate commutated thyristor (integrated gate commutated thyristor, IGCT), and the like.

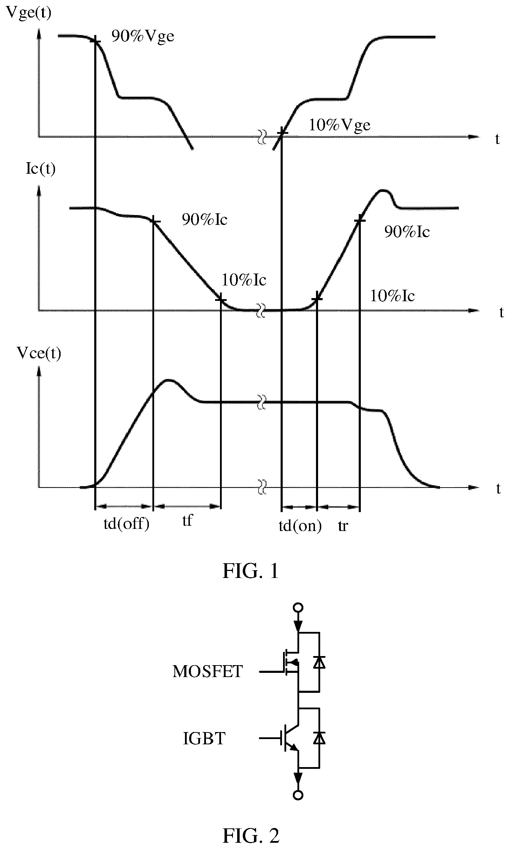

FIG. 1 is a turn-on and turn-off waveform diagram of an IGBT.

The IGBT is a composite fully-controlled voltage-driven power semiconductor device composed of a bipolar junction transistor (bipolar junction transistor, BJT) and a MOSFET, has advantages of high input impedance and low on-voltage drop, and is widely used in medium and high power converters. However, because a tailing current (tailing current) exists when the IGBT is turned off, an IGBT off time is relatively long, which affects an operating frequency of the device.

A voltage $Vge(t)$ between a gate (gate, g) and an emitter (emitter, e) of the IGBT is a control voltage of the IGBT, may also be referred to as a drive voltage of the IGBT, and controls the IGBT to be turned on and off. Vge represents a maximum value of $Vge(t)$.

$Vge(t)$ falls from Vge. When $Vge(t)$ falls to 90% Vge, the IGBT starts to be turned off, a collector (collector, c) current $Ic(t)$ starts to decrease, and a voltage $Vce(t)$ between the collector and the emitter starts to rise.

Ic represents a maximum value of $Ic(t)$. After $Vge(t)$ falls to 90% Vge, a time during which $Ic(t)$ rises from 0 to 90% Ic may be referred to as a turn-off delay time td(off), and a time during which $Ic(t)$ falls from 90% Ic to 10% Ic may be referred to as a fall time tf of Ic. Due to the existence of the trailing current, the fall time tf of Ic is relatively long.

$Vge(t)$ rises from 0. When $Vge(t)$ rises to 10% Vge, the IGBT starts to be turned on, the collector (collector, c) current $Ic(t)$ starts to increase, and the voltage $Vce(t)$ between the collector and the emitter starts to fall.

After $Vge(t)$ reaches 10% Vge, a time during which $Ic(t)$ rises to 90% Ic may be referred to as a turn-off delay time td(off), and a time during which $Ic(t)$ rises from 10% Ic to 90% Ic may be referred to as a rise time tr of Ic. Due to the existence of the trailing current, the fall time tf of Ic is longer than the rise time tr of Ic.

Because there is a stage at which neither the voltage $Vce(t)$ nor the current $Ic(t)$ is 0 in the turn-on or turn-off process, a switching loss is caused. A soft switching technology can reduce the switching loss of the IGBT. By using the soft switching technology, when the power semiconductor device is turned on or off, zero voltage switching (zero voltage switching, ZVS) can be implemented by remaining a voltage across the device at 0 or zero current switching (zero current switching, ZCS) can be implemented by remaining a current flowing through the device at 0,. The switching loss of the device can be effectively reduced by using ZVS and ZCS technologies.

FIG. 2 is a schematic diagram of a series type hybrid power device. A MOSFET and an IGBT are connected in series, so that the IGBT can implement ZCS.

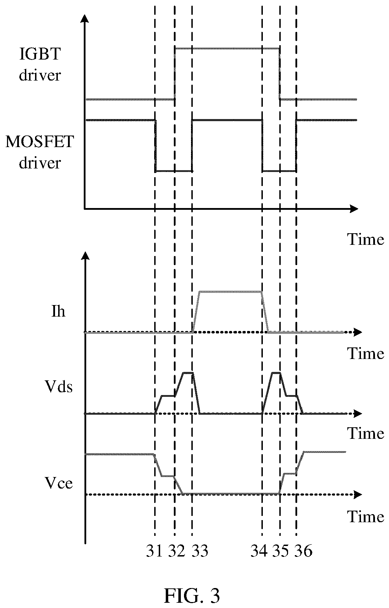

FIG. 3 is a turn-on and turn-off waveform diagram of the series type hybrid power device. The MOSFET and the IGBT are connected in series.

The IGBT can withstand a relatively high voltage. Therefore, before moment 31, the MOSFET is turned on and the IGBT is turned off, a voltage across the hybrid power device is applied between a collector and an emitter of the IGBT, namely, a collector-emitter voltage Vce between the collector and the emitter of the IGBT is a maximum value, and a source-drain voltage Vds between a source and a drain of the MOSFET is 0.

At moment 31, the MOSFET starts to be turned off and the IGBT is in a cut-off state. The voltage across the hybrid power device is divided between the MOSFET and the IGBT. After moment 31, in the turning-off process of the MOSFET, the source-drain voltage Vds of the MOSFET and the collector-emitter voltage Vce of the IGBT rise to a stable value obtained after the voltage division.

At moment 32, the IGBT starts to be turned on and the MOSFET is in a cut-off state. After moment 32, in the turn-on process of the IGBT, the collector-emitter voltage Vce of the IGBT gradually falls to 0, and the voltage across the hybrid power device is applied between the source and the drain of the MOSFET. In other words, Vds is a maximum value.

Before moment 33, at least one switch of the MOSFET and the IGBT is turned off. Therefore, a total current Ih flowing through the hybrid power device is 0. When the IGBT is turned on, no current flows through the IGBT, thereby implementing zero current turning on.

At moment 33, the MOSFET starts to be turned on, and the IGBT is in a turn-on state. After moment 33, the total current Ih flowing through the hybrid power device rises to the maximum value, the source-drain voltage Vds of the MOSFET falls to 0, and the collector-emitter voltage Vce of the IGBT is 0.

At moment 34, the MOSFET starts to be turned off, and the IGBT is in a turn-on state. After moment 34, the total current Ih falls to 0, the voltage across the hybrid power device starts to be applied to between the source and the drain of the MOSFET, namely, the source-drain voltage Vds of the MOSFET rises to the maximum value, and the collector-emitter voltage Vce of the IGBT is 0.

At moment 35, the IGBT starts to be turned off and the MOSFET is in a cut-off state. After moment 35, the voltage across the hybrid power device is divided between the MOSFET and the IGBT. After moment 31, in the turn-off process of the MOSFET, the source-drain voltage Vds of the MOSFET falls to a stable value obtained after the voltage division, and the collector-emitter voltage Vce of the IGBT rises to a stable value obtained after the voltage division. In the turn-off process of the IGBT, the total current Ih=0, thereby implementing zero current turning off.

At moment 36, the MOSFET starts to be turned on, and the IGBT is in a cut-off state. The voltage across the hybrid power device starts to be applied to between the collector and the emitter of the IGBT, the source-drain voltage Vds of the MOSFET falls to 0, and the collector-emitter voltage Vce of the IGBT rises to the maximum value.

Before moment 31 and after moment 36, the total current Ih of the series type hybrid power device is 0, and the IGBT withstands a relatively high voltage. In a switching process of the series type hybrid power device from moment 31 to moment 33 and from moment 34 to moment 36, the MOSFET is turned off, so that the IGBT implements ZCS, thereby reducing a switching loss.

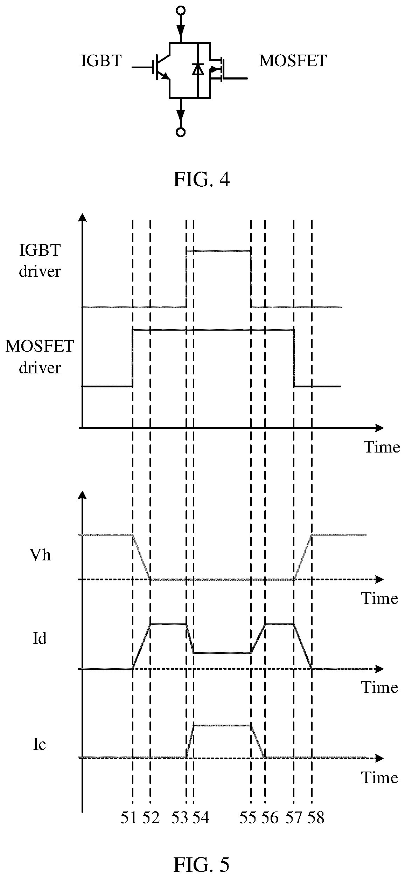

FIG. 4 is a schematic diagram of a parallel type hybrid power device. A MOSFET and an IGBT are connected in parallel, so that the IGBT can implement ZVS, thereby further reducing a turn-on loss.

FIG. 5 is a turn-on and turn-off waveform diagram of the parallel type hybrid power device. A collector-emitter voltage Vce of the IGBT is equal to a source-drain voltage Vds of the MOSFET, namely, a voltage Vh across the parallel type hybrid power device.

Before moment 51, both the IGBT and the MOSFET are in a cut-off state, the voltage Vh is a maximum value, a collector current Ic of the IGBT is equal to 0, and a drain current Id of the MOSFET is equal to 0.

At moment 51, the MOSFET starts to be turned on, and the IGBT is in a cut-off state. The voltage Vh, namely, the source-drain voltage Vds of the MOSFET, starts to fall, and the drain current Id of the MOSFET rises. The IGBT is in a cut-off state, and therefore the collector current Ic of the IGBT is equal to 0.

At moment 52, the source-drain voltage Vds of the MOSFET falls to 0, and the drain current Id of the MOSFET rises to the maximum value.

At moment 53, the IGBT starts to be turned on, and the MOSFET is in a turn-on state. The IGBT and the MOSFET start to share the current, the drain current Id of the MOSFET falls, and the collector current Ic of the IGBT rises.

At moment 54, the IGBT is fully turned on. After moment 54, both the IGBT and the MOSFET are turned on. Both the IGBT and the MOSFET have turn-on losses. The IGBT and the MOSFET in the turn-on state are equivalent to resistors in a circuit. With the same current flowing through, the two resistors are connected in parallel to reduce the turn-on losses.

At moment 55, the IGBT starts to be turned off and the MOSFET is in a turn-on state. The collector current Ic of the IGBT falls. Because the MOSFET is in the turn-on state, the voltage Vh=0, and the drain current Id of the MOSFET rises.

At moment 56, the collector current Ic of the IGBT falls to 0, and the drain current Id of the MOSFET rises to the maximum value.

At moment 57, the MOSFET starts to be turned off and the IGBT is in a cut-off state. The drain current Id of the MOSFET falls and the voltage Vh rises.

At moment 58, the drain current Id of the MOSFET falls to 0, and the voltage Vh rises to the maximum value.

A time length between moment 51 and moment 57 may be referred to as a turn-on time of the parallel type hybrid power device.

In a process of performing switching by the IGBT (from moment 53 to moment 54 and from moment 55 to moment 56), the MOSFETs are all in the turn-on state, and the collector-emitter voltage Vce of the IGBT, namely, the voltage Vh, is always 0, so that ZVS is implemented, and the switching loss can be reduced.

With the rapid development of a wide-bandgap semiconductor device technology, a wide-bandgap semiconductor device may be used in the parallel type hybrid power device. Energy of electrons in solids has discontinuous magnitudes, and electrons are distributed in some discontinuous energy bands. A gap between an energy band in which valence electrons are located and an energy band in which free electrons are located is referred to as a bandgap or a bandgap. Therefore, a bandgap width actually reflects extra energy that the bound valence electrons need to gain in order to become free electrons. A bandgap width of silicon is 1.12 electron volts (eV), and a wide-bandgap semiconductor material refers to a semiconductor material having a bandgap width of 2.3 eV or more, and is typically silicon carbide (SiC), gallium nitride (GaN), diamond, and the like. The wide-bandgap semiconductor material is referred to as a third generation semiconductor material. A device prepared from the wide-bandgap semiconductor material may be referred to as a wide-bandgap semiconductor device.

A silicon material preparation device may also be referred to as a silicon (Si) device. Compared with a conventional silicon device, the wide-bandgap semiconductor device has a smaller switching rate and a lower switching loss. The switching loss of the device is related to a time it takes for the device to perform switching. Generally, a longer switching time of the device indicates a larger switching loss. The switching loss can be reduced by using the wide-bandgap semiconductor device.

In a specific operating condition and an application requirement, an on-state holding time of the parallel type hybrid power device is relatively short, and a switching manner of the parallel type hybrid power device shown in FIG. 5 cannot be implemented.

A power semiconductor device has a limited switching speed, and a certain pulse width of a control signal of the power semiconductor device needs to ensure to avoid a switching failure of the power semiconductor device. If the pulse width of the control signal of the device is relatively small, a current flowing through the device cannot reach a preset current value. In other words, the device cannot be fully turned on. If the device is not fully turned on, an equivalent resistance of the device is relatively large, and the device generates relatively large power consumption, which adversely affects the circuit.

When a switching failure of the device occurs, the device cannot be fully turned on, and an output of the device is inconsistent with an expected output result. In other words, output distortion occurs. The output distortion may also be referred to as output distortion.

In other words, when the pulse width of the control signal of the device is relatively small and a switching failure of the device occurs, on one hand, the device cannot be turned on or off effectively, which causes an output distortion problem; on the other hand, a switching loss is caused in the switching process of the device.

For the problem of the limited switching speed of the power semiconductor device, the minimum pulse width limit of the device may be set to reduce the switching loss. A shortest pulse width at which the device can be effectively turned on or off without a switching failure may be used as the minimum pulse width limit. Pulse width is pulse width. The minimum pulse width limit may also be slightly greater than the shortest pulse width at which the device can be effectively turned on or off. The minimum pulse width limit, which may also be referred to as a minimum pulse width, is determined based on the switching speed of the device. The minimum pulse width limit of the switching device refers to a minimum pulse width time of the control signal set to ensure that the switching device is fully turned and/or off. In this embodiment of this application, the minimum pulse width limit can enable the switching device to be effectively turned on.

The pulse width of the control signal of the device may be referred to as a state holding time. When it is determined that the state holding time is less than the minimum pulse width limit of the device, wave blocking processing may be performed. In other words, a value relationship between the state holding time and the minimum pulse width limit of the device is determined. If the state holding time is less than the minimum pulse width limit, no pulse is generated within the state holding time when the control signal is generated, and the control signal remains unchanged. It should be understood that the device may be in a turn-on or cut-off state before the state holding time.

The parallel type hybrid power device may operate in a pulse width modulation (PWM) mode. PWM is a very effective technology for controlling an analog circuit using a digital output. In the PWM mode, the parallel type hybrid power device performs a switching operation periodically. A pulse width of a pulse signal is a time during which the device is required to be in a turn-on state, and is also referred to an on-state holding time. A duty cycle is a ratio of the on-state holding time to a switching cycle.

When the time during which the parallel type hybrid power device is required to be in a turn-on state, namely, the on-state holding time, is less than the minimum pulse width limit of the device, through the wave blocking processing, the device performs no switching operation and remains in the cut-off state. Therefore, the loss of the device can be reduced, but the output distortion problem is more serious.

For the parallel type hybrid power device, an improper switching control manner may lead to relatively large output distortion and relatively high power consumption.

In a case of a low duty cycle in the PWM mode, namely, when the on-state holding time is relatively short, there is no effective solution to a problem of how to control the parallel type hybrid power device to enable the parallel type hybrid power device to perform a switching operation and implement effective switching within a smaller on-state holding time and a wider duty cycle range, to reduce output distortion while reducing power consumption.

To resolve the foregoing problem, an embodiment of this application provides a control method for a switching apparatus. The switching apparatus includes at least two switching devices connected in parallel. Among the at least two switching devices, a first switching device has a minimum pulse width limit. When an on-state holding time is greater than or equal to the pulse width limit of the first switching device, the first switching device performs a switching operation, so that the switching apparatus can implement effective switching within a relatively wide duty cycle range, thereby reducing a switching loss and output distortion.

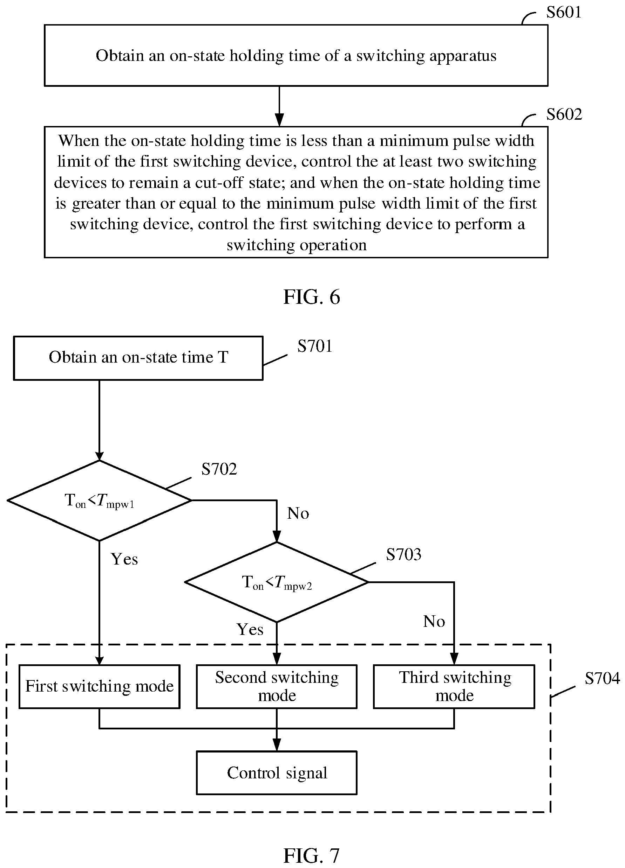

FIG. 6 is a schematic flowchart of a control method for a switching apparatus according to an embodiment of this application.

The switching apparatus includes at least two switching devices connected in parallel. The at least two switching devices include a first switching device and a second switching device. Among the at least two switching devices, a minimum pulse width limit of the first switching device is less than a minimum pulse width limit of the second switching device.

A faster switching speed of the switching device indicates a smaller minimum pulse width limit of the switching device. The switching speed of the switching device may be determined by many factors such as a material, a processing process, a process size, a device type, and a voltage value of a control signal.

The switching speed of the switching device is determined based on a turn-on time and/or a turn-off time of the switching device. The minimum pulse width limit of the switching device may be determined based on the turn-on time and/or the turn-off time of the switching device. The minimum pulse width limit of the switching device may be a preset value.

The turn-on time of the switching device may be equal to a current rise time of the switching device. The current rise time of the switching device may be a time at which a current flowing through the switching device rises from a first preset current value to a second preset current value in a turn-on process of the switching device, where the second preset current value is greater than the first preset current value. The first preset current value may be, for example, 10% of a maximum current value when the switching device is turned on, and the second preset current value may be, for example, 90% of the maximum current value when the switching device is turned on.

The turn-on time of the switching device may further be affected by a turn-on delay time. The turn-on time of the switching device may be equal to a sum of the current rise time and the turn-on delay time of the switching device. The turn-on delay time of the switching device may be a time from a time at which a control signal of the switching device flips to a time at which the current flowing through the switching device rises to the first preset current value in the turn-on process of the switching device.

A current fall time of the switching device may be a time at which the current flowing through the switching device decreases from a third preset current value to a fourth preset current value in a turn-off process of the switching device, where the third preset current value is less than the fourth preset current value. The third preset current value is, for example, 90% of the maximum current value when the switching device is turned on, and the fourth preset current value may be, for example, 10% of the maximum current value when the switching device is turned on.

The turn-off time of the switching device may further be affected by a turn-off delay time. The turn-off time of the switching device may be equal to a sum of the current fall time and the turn-off delay time of the switching device. The turn-off delay time of the switching device may be a time from a time at which the control signal of the switching device starts to flip to a time at which the current flowing through the switching device falls to the third preset current value in a turn-off process of the switching device.

The minimum pulse width limit of the switching device may be greater than or equal to a positive integer multiple of the turn-on time of the switching device or a positive integer multiple of the turn-off time, or may be greater than or equal to a sum of the current rise time and the current fall time. Alternatively, the minimum pulse width limit of the switching device may be a time length obtained by adding the turn-on delay time and/or subtracting the turn-off delay time on the basis of being greater than or equal to the sum of the current rise time and the current fall time.

In the turn-on process, if the current flowing through the switching device, namely, the current of the switching device, reaches the second preset value, it may be considered that the switching device is effectively turned on, and an effective turn-on operation is implemented. In the turn-off process, if the current flowing through the switching device reaches the fourth preset value, it may be considered that the switching device is effectively cut off, and an effective turn-off operation is implemented.

In the turn-on process of the switching device, a time point at which the control signal of the switching device flips or a time point at which the control signal of the switching device starts to flip may be considered as that the voltage of the control signal reaches a preset turn-on value. If the control signal of the switching device flips from a high level to a low level to control the switching device to be turned on, a preset turn-on value of a control voltage may be a high-level voltage value minus 10% of a voltage difference between the high-level voltage value and a low-level voltage value. If a control voltage of the switching device flips from a low level to a high level to control the switching device to be turned on, a preset turn-on value of the control voltage may be a low-level voltage value plus 10% of a voltage difference between a high-level voltage value and the low-level voltage value.

In the turn-off process of the switching device, a time point at which the control signal of the switching device flips or a time point at which the control signal of the switching device starts to flip may be considered as that the voltage of the control signal reaches a preset turn-off value. If the control signal of the switching device flips from a high level to a low level to control the switching device to be turned off, a preset turn-off value of a control voltage may be a high-level voltage value minus 10% of a voltage difference between the high-level voltage value and a low-level voltage value. If a control voltage of the switching device flips from a low level to a high level to control the switching device to be turned off, a turn-off delay time of the control voltage may be a low-level voltage value plus 10% of a voltage difference between a high-level voltage value and the low-level voltage value.

The high-level voltage value is a high-level minimum voltage value. When the voltage of the control signal is greater than or equal to the high-level voltage value, the control signal is at high level. The low-level voltage value is a low-level maximum voltage value. When the voltage of the control signal is less than or equal to the low-level voltage value, the control signal is at low level. The high level may be represented by 1 and the low level may be represented by 0.

The wide-bandgap semiconductor device has a relatively high switching speed. A material of the first switching device may be a wide-bandgap semiconductor material, and a material of the second switching device may be a silicon material. It should be understood that the material of the first switching device being a wide-bandgap semiconductor material means that a main material of the first switching device is the wide-bandgap semiconductor material, or the first switching device is prepared and formed on the wide-bandgap semiconductor material. In a semiconductor process, silicon is the main elemental semiconductor material, including silicon polycrystalline, silicon monocrystalline, silicon wafer, silicon epitaxial wafer, amorphous silicon film, and the like, which may be directly or indirectly used to prepare a semiconductor device.

In step S601, an on-state holding time of the switching apparatus is obtained.

The switching apparatus may be in two stable states: a turn-on state and a cut-off state. When the switching apparatus is in the turn-on state, the first switching device or the second switching device or both are in the turn-on state. When the switching apparatus is in the cut-off state, both the first switching device and the second switching device are in the cut-off state.

The on-state holding time may be a time during which the switching apparatus is in the turn-on state in an ideal state. The switching device in the switching apparatus is controlled by a control signal. In the ideal state, within the on-state holding time, at least one of a control signal of the first switching device and a control signal of the second switching device controls a time during which the switching device corresponding to the control signal is in the turn-on state.

It should be understood that the switching apparatus is in the cut-off state before the on-state holding time.

A control signal of the switching apparatus may be obtained. The control signal of the switching apparatus is a signal that controls the switching apparatus to be represented in the turn-on state or the cut-off state as a whole. The on-state holding time may be determined based on a period and a duty cycle of the control signal of the switching apparatus.

Alternatively, state indication information may be obtained, where the state indication information is used to indicate the on-state holding time.

In step S602, when the on-state holding time is less than the minimum pulse width limit of the first switching device, the at least two switching devices are controlled to remain in a cut-off state; and when the on-state holding time is greater than or equal to the minimum pulse width limit of the first switching device, the first switching device is controlled to perform a switching operation.

A minimum pulse width limit of one switching device may be determined based on a switching speed of the switching device. The switching speed of the switching device may be reflected by a turn-on delay time, a current rise time, a turn-off delay time, and a current fall time. The minimum pulse width limit of the switching device may be determined based on one or more of the turn-on delay time, the current rise time, the turn-off delay time, the current fall time, and the like. In this embodiment of this application, the minimum pulse width limit may also be referred to as an on-state minimum pulse width limit, namely, a minimum width of a pulse that controls the switching device to be turned on.

The switching device in the switching apparatus is controlled to generate a control signal of each of the at least two switching devices, to separately control each switching device.

When the on-state holding time is greater than or equal to the minimum pulse width limit of the first switching device, a first control signal of the first switching device flips, and the first switching device is controlled to perform a switching operations, so that the switching apparatus can perform an effective switching operation within a relatively small pulse width range.

A pulse width (also referred to as pulse width) of the first control signal may be equal to the on-state holding time. In other words, the first control signal flips at the start of the on-state holding time, to control the first switching device to be turned on; and the first control signal flips again at the end of the on-state holding time, to control the first switching device to be turned off.

The second switching device is another one of the at least two switching devices. Compared with the first switching device, the second switching device has a slower switching speed, and therefore has a longer minimum pulse width limit of the second switching device.

When the on-state holding time is less than the minimum pulse limit of the second switching device, the control signal of the second switching device may not flip, namely, the second switching device remains in the cut-off state, thereby avoiding a switching failure of the second switching device and reducing a switching loss of the second switching device.

A control signal flipping means that a level of the control signal changes from a high level to a low level or from a low level to a high level. In other words, a voltage of the control signal changes. A time point at which the control signal flips may be a time point at which the control signal reaches a preset value. In a turn-on process of the switching device, a time point at which the control signal reaches a preset turn-on value is a time point at which the control signal flips. In a turn-off process of the switching device, a time point at which the control signal reaches a preset turn-off value is a time point at which the control signal flips.

When a value of the on-state holding time falls between the minimum pulse width limit of the first switching device and the minimum pulse width limit of the second switching device, only the first switching device performs a switching operation. The switching failure caused by the switching operation of the second switching device when the on-state holding time does not meet the minimum pulse width limit of the second switching device is avoided, the switching loss of the second switching device is reduced, and the loss of the switching apparatus is reduced as a whole.

When the on-state holding time is greater than or equal to the minimum pulse width limit of the second switching device, the first switching device and the second switching device may be controlled to perform switching operations. When the first switching apparatus and the second switching apparatus are both in the turn-on state, it is equivalent to that two resistors are connected in parallel, and a total resistance is reduced, so that a turn-on loss of the switching apparatus can be reduced and a current tolerance capability of the switching apparatus can be increased.

Compared with the second switching device, the first switching device has a smaller switching loss because the first switching device has a high switching speed and has a smaller minimum pulse width limit.

When both the first switching device and the second switching device perform switching operations to be turned on, the first switching device may be controlled to start to be turned on before the second switching device. The first switching device has a short switching time and a small switching loss, and is turned on before the second switching device, so that the loss generated by turning on the second switching device can be reduced, thereby reducing the loss of the switching apparatus.

The first control signal flips and after a delay time, the second control signal flips to control the first switching device and the second switching device to be turned on, where the turn-on time difference is greater than or equal to zero. In other words, when the first switching device and the second switching device are controlled to be turned on, the first control signal flips no later than the second control signal. The first control signal flips before the second control signal, or the first control signal and the second control signal flip simultaneously, to control the first switching device and the second switching device to be turned on.

The turn-on time difference may be a difference between the on-state holding time and the minimum pulse width limit of the second switching device. The turn-on time difference may also be a preset value. For example, the turn-on time difference may be equal to the turn-on time of the first switching device, or the turn-on time difference may be determined based on the current rise time of the first switching device, or may be determined based on the current rise time of the first switching device, and the turn-on delay time of the first switching device and/or the turn-on delay time of the second switching device. The turn-on time difference may alternatively be determined based on one or more factors of a material, a processing process, a device size, and the like of the first switching device and the second switching device.

When the first switching device and the second switching device are turned on, the first control signal flips before the second control signal or the first control signal and the second control signal flip simultaneously, so that the first switching device can be turned on before the second switching device. In other words, in a process of switching the second switching device from the cut-off state to the on-state, the first switching device has been turned on or is being turned on. Therefore, a voltage across the second switching device is reduced, and a loss in the turn-on process of the second switching device can be reduced to some extent.

The turn-on time of the switching device is a rise time of a current flowing through the device, namely, the current flowing through the device rises from 10% of a maximum current value to 90% of the maximum current value (in some cases, the turn-on time may also be considered as a fall time of a voltage across the device, namely, the voltage across the device falls from 90% of a maximum voltage value to 10% of the maximum voltage value). Considering the impact of the turn-on delay time, the turn-on time of the switching device may be expressed as a sum of the turn-on delay time of the switching device and the rise time of the current flowing through the device (or the fall time of the voltage across the device).

When both the first switching device and the second switching device perform switching operations to be turned off, the first switching device may be controlled to be turned off after the second switching device, and enter the cut-off state.

In other words, the second control signal flips and after a turn-off time difference, the first control signal flips to control the first switching device and the second switching device to be turned off, where the turn-off time difference is greater than zero. When the first switching device and the second switching device are turned off, the first control signal flips later than the second control signal.

The turn-off time difference may be a difference between the on-state holding time and the minimum pulse width limit of the second switching device. The turn-off time difference may also be a preset value. For example, the turn-off time difference may be equal to the turn-off time of the second switching device, and the turn-off time difference may alternatively be determined based on the current fall time of the second switching device, or determined based on the current fall time of the second switching device, and the turn-off delay time of the first switching device and/or the turn-off delay time of the second switching device. The turn-off time difference may alternatively be determined based on one or more factors such as a material, a processing process, a device size, and the like of the first switching device and the second switching device.

When both the first switching device and the second switching device perform switching operations to be turned off, the first control signal of the first switching device may flip after the second control signal of the second switching device. In the process of switching the second switching device from the turn-on state to the cut-off state, if the first switching device is in the turn-on state or is in the process of switching from the turn-on state to the cut-off state, the voltage across the second switching device is relatively low, and the loss of the second switching device in the turn-off process can be reduced to some extent. The first switching device is controlled to be turned off later than the second switching device, to reduce a time during which the first switching device is in the cut-off state in the turn-off process of the second switching device, so that the first switching device bears a main turn-off loss as much as possible, and the loss of the switching apparatus is reduced.

Regardless of the impact of the turn-off delay time, the turn-off time of the switching device is a fall time of a current flowing through the device, or may be considered as a rise time of a voltage across the device. Considering the impact of the turn-off delay time, the turn-off time of the switching device may be represented as a sum of the turn-off delay time of the switching device and the fall time of the current flowing through the device (or the turn-off delay time of the switching device and the rise time of the voltage across the device).

For the IGBT, compared with the turn-on operation, the IGBT has a larger loss during the turn-off operation. Therefore, when the switching device with a relatively large switching loss is an IGBT, if the on-state holding time is relatively short, the IGBT is preferentially controlled to implement zero voltage turning off.

When both the first switching device and the second switching device perform switching operations, when the first switching device and the second switching device are turned on or off, a time difference between a time at which the control signal of the first switching device flips and a time at which the control signal of the second switching device flips may be implemented by using a digital circuit or an analog circuit.

The at least two switching devices connected in parallel in the switching apparatus may be power devices. Because the power device is configured to process a large voltage and a large current, the loss problem of the power device is more serious.

A control manner of another one of the at least two switching devices in the switching apparatus is similar to that of the second switching device.

It should be understood that the method provided in this embodiment of this application should be performed when a load current does not exceed an upper limit of a safe operating area current of each of the at least two switching devices connected in parallel, to avoid device damage.

The switching apparatus includes at least two switching devices connected in parallel, where the first switching device has a minimum value of the minimum pulse limit. Through step S601 to step S602, when the on-state holding time is greater than or equal to the minimum pulse width limit of the first switching device, the first switching device is controlled to perform a switching operation, so that the switching apparatus can implement effective switching when the on-state holding time is relatively short. Compared with a method of generating control signals of all switching devices based on minimum pulse width limits of other switching devices, the method provided in this embodiment of this application can reduce output distortion caused by wave blocking processing while reducing power consumption.

The at least two switching devices may further include a third switching device. A minimum pulse width limit of the third switching device may be greater than, less than, or equal to the minimum pulse width limit of the first switching device. Compared with a method of setting pulse width limits for all switching devices in the switching apparatus based on a maximum value of the minimum pulse width limit among the at least two switching devices, the method provided in this embodiment of this application can effectively reduce the output distortion.

Preferably, among the at least two switching devices, the first switching device has a minimum value of the minimum pulse width limit. Therefore, the output distortion of the switching apparatus is minimized while the power consumption is reduced.

Preferably, for each of the at least two switching devices, when an on-state holding time is less than a minimum pulse width limit of the switching device, the switching device is controlled to remain in a cut-off state; and when the on-state holding time is greater than or equal to the minimum pulse width limit of the switching device, the switching device is controlled to perform a switching operation, thereby reducing a switching loss.

FIG. 7 is a schematic flowchart of a control method for a switching apparatus according to an embodiment of this application.

In step S701, an on-state holding time $T_{on}$ of the switching apparatus is obtained.

In step S702, values of the on-state holding time $T_{on}$ and $T_{mpw1}$ are determined.

The switching apparatus includes a first switching device and a second switching device connected in parallel. A minimum pulse width limit of the first switching device is $T_{mpw1}$, a minimum pulse width limit of the second switching device is $T_{mpw2}$, values of $T_{mpw1}$ and $T_{mpw2}$ are not equal, and $T_{mpw1}<T_{mpw2}$. When the on-state holding time $T_{on}$ is greater than or equal to the minimum pulse width limit of the switching device, a switching failure of the device does not occur.

The minimum pulse width limit may be determined based on one or more of a turn-on delay time, a current rise time, a turn-off delay time, and a current fall time of the power device. The minimum pulse width limit of the switching device is related to process parameters such as a size and a material of the device. The minimum pulse width limit of the switching device may be an empirical value.

The minimum pulse width limit may be preset. Before step S701 is performed, the minimum pulse width limit $T_{mpw1}$ of the first switching device and the minimum pulse width limit $T_{mpw2}$ of the second switching device may be saved.

When the on-state holding time $T_{on}$ is less than $T_{mpw1}$, a control signal of the first switching device and a control signal of the second switching device are generated based on a first switching mode in step S704. In the first switching mode, neither the first switching device nor the second switching device performs switching, and both the first switching device and the second switching device are in a cut-off state.

When the on-state holding time $T_{on}$ is greater than or equal to $T_{mpw1}$, step S703 is performed.

In step S703, values of the on-state holding time $T_{on}$ and $T_{mpw2}$ are determined.

If the on-state holding time $T_{on}$ is less than $T_{mpw2}$, namely, $T_{mpw1}<T_{on}<T_{mpw2}$, a control signal of the first switching device and a control signal of the second switching device are generated based on a second switching mode in step S704.

In the second switching mode, the first switching device corresponding to $T_{mpw1}$ performs a switching operation, and the second switching device corresponding to $T_{mpw2}$ performs no switching operation, and is in a cut-off state. In the control signal of the first switching device, a time during which the first switching device is controlled to be in a turn-on state is equal to the on-state holding time $T_{on}$. In other words, a pulse width for controlling the first switching device to be turned on in the control signal is equal to the on-state holding time $T_{on}$.

If the on-state holding time $T_{on}$ is greater than or equal to $T_{mpw2}$ ($T \geq T_{mpw2}$), the control signal of the first switching device and the control signal of the second switching device are generated based on a third switching mode in step S704.

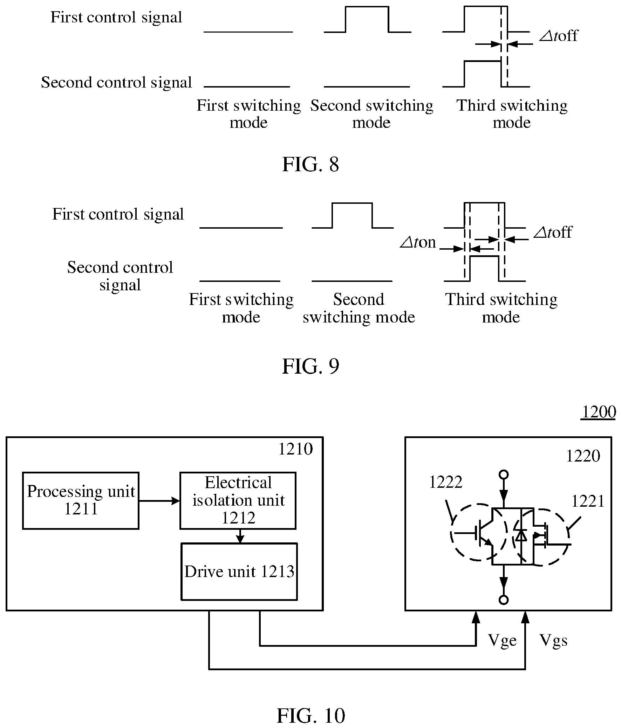

In the third switching mode, both the first switching device and the second switching device perform switching operations. In the control signal of the first switching device, a pulse width for controlling the first switching device to be in a turn-on state is equal to the on-state holding time $T_{on}$. For the control signals of the first switching device and the second switching device, refer to the descriptions of FIG. 8 and FIG. 9.

According to the control method for a switching apparatus provided in this embodiment of this application, two switching devices connected in parallel are controlled based on the on-state holding time of the switching apparatus.

Because the two switching devices connected in parallel have different switching speeds, different minimum pulse width limits may be set for the two switching devices respectively based on the switching speeds of the two switching devices. Therefore, when the on-state holding time is less than respective minimum pulse width limits of the two switching devices, namely, less than the smaller minimum pulse width limit of the two switching devices, the two switching devices are both in the cut-off state and perform no switching operation, to avoid a switching failure.

When the on-state holding time is relatively small but the on-state holding time is greater than the smaller minimum pulse width limit of the two switching devices, the switching apparatus may be enabled to operate in the second switching mode, and the switching device with the smaller minimum pulse width limit may independently perform a switching operation, so that the switching apparatus can implement an effective switching operation within a wider duty cycle range, thereby reducing the output distortion caused by the minimum pulse width limit of the switching device.

When the on-state holding time is relatively large and is greater than respective minimum pulse width limits of the two switching devices, the switching apparatus is enabled operate in the third switching mode, and both the two switching devices perform switching operations, thereby reducing a turn-on loss. Because a switching loss of the first switching device is lower than a switching loss of the second switching device, the first switching device and the second switching device may be turned on at the same time or the first switching device be turned on earlier than the second switching device and turned off later than the first switching device, so that the first switching device mainly bears the switching loss. The parallel connection of the first switching device and the second switching device enables the switching device with the smaller turn-on loss to mainly bear the turn-on loss, thereby implementing soft switching of the second switching device, utilizing the advantage of a low switching loss of the first switching device, and reducing the loss of the switching apparatus.

In FIG. 8 and FIG. 9, the switching loss of the first switching device is less than the switching loss of the second switching device. The second switching device may be, for example, an IGBT. For the IGBT, the turn-off process generates a larger loss than the turn-on process.

FIG. 8 is a waveform diagram of a control signal according to an embodiment of this application;

A switching apparatus includes a first switching device and a second switching device connected in parallel, and both the first switching device and the second switching device are power switching devices. The first switching device is a wide-bandgap semiconductor device, for example, a silicon carbide (SiC) device, a gallium nitride (GaN) device, or a diamond device. The second switching device is a silicon device. In FIG. 8 and FIG. 9, an example in which the first switching device is a SiC MOSFET, and the second switching device is a Si IGBT is used for description.

The first switching device and the second switching device are independently controlled by respective control signals. For a manner of generating a control signal, refer to the description in FIG. 7.

A switching mode of the switching apparatus is determined based on a value relationship between a turn-on time $T_{on}$ of the switching apparatus and a minimum pulse width limit $T_{mpw1}$ of the first switching device and/or a minimum pulse width limit $T_{mpw2}$ of the second switching device. $T_{mpw1} < T_{mpw2}$

A pulse control signal of the switching apparatus may be obtained, and an on-state holding time $T_{on}$ of the switching apparatus may be determined based on the pulse control signal. A pulse period of the pulse control signal is Ts and a duty cycle is D. Therefore, the on-state holding time of the switching apparatus is $T_{on} = D \times Ts$.

When the duty cycle D of the pulse control signal

$$D < \frac{T_{mpw1}}{Ts}$$

meets, a first switching mode is selected. In the first switching mode, both the first switching device and the second switching device are cut off, to prevent a switching failure, thereby reducing a loss.

When the duty cycle D of the pulse control signal

$$\frac{T_{mpw1}}{Ts} \leq D < \frac{T_{mpw2}}{Ts}$$

meets, a second switching mode is selected. In the second switching mode, the second switching device is cut off and the first switching device is turned on and off independently. The first switching device may operate in a pulse width modulation (PWM) mode. The on-state holding time of the switching apparatus is equal to a time length during which a level of the control signal of the first switching device is a level for controlling the first switching device to be in a turn-on state, and may be represented as $D \times Ts$. The level for controlling the first switching device to be in a turn-on state is determined based on a type of the first switching device, and may be a high level or a low level.

When the duty cycle D of the pulse control signal

$$D \geq \frac{T_{mpw2}}{Ts}$$

meets, a third switching mode is selected. In the third switching mode, both the first switching device and the second switching device perform switching operations. In other words, both the first switching device and the second switching device operate in the PWM mode.

The first switching device and the second switching device may simultaneously start to perform turn-on operations, or the first switching device may perform a turn-on operation earlier than the second switching device, so that the first switching device completes the turn-on operation earlier than the second switching device, and enters a turn-on state.

The first switching device may start to perform a turn-off operation later than the second switching device, so that the first switching device does not enter a cut-off state before the second switching device enters a cut-off state. Therefore, the first switching device mainly bears a turn-off loss. A time difference between a moment at which the first switching device starts to be turned off and a moment at which the second switching device starts to be turned off may be referred to as a turn-off time difference Δtoff.

Optionally, the first switching device may alternatively be turned on earlier than the second switching device.

As shown in FIG. 9, a time difference between a moment at which the first switching device starts to be turned on and a moment at which the second switching device starts to be turned on may be referred to as a turn-on time difference Δton.

A time during which the control signal of the first switching device controls the power device to be in the turn-on state may be $D \times Ts$.

The first switching device uses a wide-bandgap semiconductor material, which has a high switching speed and a low switching loss. The second switching device is an IGBT, and has a small turn-on loss.

The first switching device and the second switching device are turned on simultaneously or the first switching device is turned on earlier than the second switching device and turned off later than the first switching device, thereby implementing soft switching of the second switching device, so that the first switching device mainly bears a switching loss. When the first switching device and the second switching device are turned on, the second switching device can mainly bear a turn-on loss. The control method for a switching apparatus provided in this embodiment of this application combines advantages of a low switching loss of the first switching device and a low turn-on loss of the second switching device, and reduces a loss of the switching apparatus.

According to the control method for a switching apparatus provided in this embodiment of this application, an effective switching operation of the switching apparatus can be implemented within a wider duty cycle range, and output distortion caused by the minimum pulse width limit can be reduced. In addition, at a high duty cycle, soft switching of the silicon device can be implemented and the switching loss can be reduced.

The foregoing describes the method embodiments of the embodiments of this application with reference to FIG. 1 to FIG. 9. The following describes the apparatus embodiments of the embodiments of this application with reference to FIG. 10 to FIG. 12. It should be understood that the description of the method embodiments corresponds to the description of the apparatus embodiments. Therefore, for a part not described in detail, refer to the foregoing method embodiments.

FIG. 10 is a schematic structural diagram of a switchgear according to an embodiment of this application.

The switchgear includes a control module 1210 and a switching apparatus 1220.

The control module 1210 is configured to control a first switching device 1221 and a second switching device 1222 in the switching apparatus 1220 to be turned on and off. The first switching device 1221 may be a SiC MOSFET, and the second switching device 1222 may be a Si IGBT.

The control module 1210 includes a processing unit 1211, an electrical isolation unit 1212, and a drive unit 1213.

The processing unit 1211 is configured to perform the method shown in FIG. 6 or FIG. 7, and control the first switching device 1221 and the second switching device 1222. The processing unit 1211 may generate a control signal of the first switching device 1221 and a control signal of the second switching device 1222. The control signal of the first switching device 1221 and the control signal of the second switching device 1222 may be PWM signals.

The control signals are transmitted to the drive unit 1213 through the electrical isolation unit 1212. In the electrical isolation unit 1212, electrical isolation may be implemented in a magnetic coupling or optical coupling manner, and signal transmission may be implemented.

The drive unit 1213 generates a drive signal Vds of the first switching device 1221 based on the received control signal of the first switching device 1221, and generates a drive signal Vge of the second switching device 1222 based on the received control signal of the second switching device 1222, thereby implementing drive of the switching apparatus 1220. In some cases, the drive signal may also be referred to as a control signal.

It should be understood that the processing unit 1211 and the drive unit 1213 may be implemented by using a digital circuit, an analog circuit, or a digital-analog hybrid circuit.

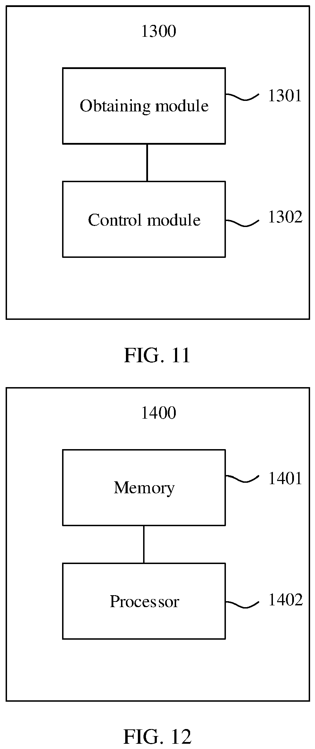

FIG. 11 is a schematic structural diagram of a control apparatus for a switching apparatus according to an embodiment of this application.

The switching apparatus includes at least two switching devices connected in parallel, and among the at least two switching devices, a minimum pulse width limit of a first switching device is less than a minimum pulse width limit of a second switching device, and the first switching device and the second switching device are in a cut-off state.

The apparatus 1300 includes an obtaining module 1301 and a control module 1302.

The obtaining module 1301 is configured to obtain an on-state holding time of the switching apparatus.

The control module 1302 is configured to: control, when the on-state holding time is less than the minimum pulse width limit of the first switching device, the at least two switching devices to remain in the cut-off state; and control, when the on-state holding time is greater than or equal to the minimum pulse width limit of the first switching device, the first switching device to perform a switching operation.

Optionally, the at least two switching devices include a second switching device.

The control module 1302 is further configured to: control, when the on-state holding time is greater than or equal to the minimum pulse width limit of the second switching device, the first switching device and the second switching device to perform switching operations.

Optionally, the control module 1302 is configured to generate a first control signal of the first switching device and a second control signal of the second switching device, where when the first switching device and the second switching device are turned on, a time point at which the first control signal flips is not later than a time point at which the second control signal flips.

Optionally, the control module 1302 is configured to generate a first control signal of the first switching device and a second control signal of the second switching device, where when the first switching device and the second switching device are turned off, a time point at which the first control signal flips is later than a time point at which the second control signal flips.

Optionally, the first switching device is a wide-bandgap semiconductor device, and the second switching device is a silicon device.

In other words, a material of the first switching device is a wide-bandgap semiconductor material, and a material of the second switching device is a silicon material.

Optionally, the at least two switching devices are power semiconductor devices.

Optionally, among the at least two switching devices, the first switching device has a minimum value of the minimum pulse width limit.

Optionally, the minimum pulse width limit of the first switching device is determined based on a turn-on time of the first switching device and/or a turn-off time of the first switching device.

FIG. 12 is a schematic structural diagram of a control apparatus for a switching apparatus according to an embodiment of this application.

The switching apparatus includes at least two switching devices connected in parallel, and among the at least two switching devices, a minimum pulse width limit of a first switching device is less than a minimum pulse width limit of a second switching device, and the first switching device and the second switching device are in a cut-off state.

The apparatus 1400 includes a memory 1401 and a processor 1402.

The memory 1401 is configured to store a program.

When the program is executed in the apparatus 1400, the processor 1402 is configured to:

> obtain an on-state holding time of the switching apparatus;
> control, when the on-state holding time is less than the minimum pulse width limit of the first switching device, the at least two switching devices to remain in the cut-off state; and
> control, when the on-state holding time is greater than or equal to the minimum pulse width limit of the first switching device, the first switching device to perform a switching operation.

Optionally, the processor 1402 is further configured to: control, when the on-state holding time is greater than or equal to the minimum pulse width limit of the second switching device, the first switching device and the second switching device to perform switching operations.

Optionally, the processor 1402 is configured to generate a first control signal of the first switching device and a second control signal of the second switching device, where when the first switching device and the second switching device are turned on, a time point at which the first control signal flips is not later than a time point at which the second control signal flips.

Optionally, the processor 1402 is configured to generate a first control signal of the first switching device and a second control signal of the second switching device, where when the first switching device and the second switching device are turned off, a time point at which the first control signal flips is later than a time point at which the second control signal flips.

Optionally, the first switching device is a wide-bandgap semiconductor device, and the second switching device is a silicon device.

Optionally, the at least two switching devices are power semiconductor devices.

Optionally, among the at least two switching devices, the first switching device has a minimum value of the minimum pulse width limit.

Optionally, the minimum pulse width limit of the first switching device is determined based on a turn-on time of the first switching device and/or a turn-off time of the first switching device.

An embodiment of this application further provides a control apparatus for a switching apparatus. The apparatus includes at least one processor and a communications interface, the communications interface is used by a communications apparatus to exchange information with another communications apparatus, and when program instructions are executed in the at least one processor, the communications apparatus is enabled to perform the method described above.

An embodiment of this application further provides a computer program storage medium. The computer program storage medium has program instructions, and when the program instructions are directly or indirectly executed, the method described above is implemented.

An embodiment of this application further provides a chip system. The chip system includes at least one processor, and when program instructions are executed in the at least one processor, the method described above is implemented.

An embodiment of this application further provides a switchgear, including the switching apparatus described above and a control apparatus of the switching apparatus.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in the embodiments of this application. The foregoing storage medium includes: any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A control method for a switching apparatus to reduce output distortion while reducing a loss, wherein the switching apparatus comprises at least two switching devices connected in parallel, and among the at least two switching devices, a minimum pulse width limit of a first switching device is less than a minimum pulse width limit of a second switching device, and the first switching device and the second switching device are in a cut-off state; and
the method comprises:

    obtaining (S601) an on-state holding time of the switching apparatus;
    controlling (S602), when the on-state holding time is less than the minimum pulse width limit of the first switching device, the at least two switching devices to remain in a cut-off state;
    controlling (S602), when the on-state holding time is greater than or equal to the minimum pulse width limit of the first switching device, the first switching device to perform a switching operation;
    controlling, when the on-state holding time is less than the minimum pulse width limit of the second switching device, the second switching device to remain in a cut-off state; and
    controlling, when the on-state holding time is greater than or equal to the minimum pulse width limit of the second switching device, the first switching device and the second switching device to perform switching operations.

2. The method according to claim 1, wherein the controlling, when the on-state holding time is greater than or equal to the minimum pulse width limit of the second switching device, the first switching device and the second switching device to perform switching operations comprises:
generating a first control signal of the first switching device and a second control signal of the second switching device, wherein when the first switching device and the second switching device are turned on, a time point at which the first control signal flips is not later than a time point at which the second control signal flips.

3. The method according to claim 1, wherein the controlling, when the on-state holding time is greater than or equal to the minimum pulse width limit of the second switching device, the first switching device and the second switching device to perform switching operations comprises:
generating a first control signal of the first switching device and a second control signal of the second switching device, wherein when the first switching device and the second switching device are turned off, a time point at which the first control signal flips is later than a time point at which the second control signal flips.

4. The method according to any one of claims 1 to 3, wherein a material of the first switching device is a wide-bandgap semiconductor material, and a material of the second switching device is a silicon material.

5. The method according to any one of claims 1 to 4, wherein both the at least two switching devices are power semiconductor devices.

6. The method according to any one of claims 1 to 5, wherein the minimum pulse width limit of the first switching device is determined based on a turn-on time of the first switching device and/or a turn-off time of the first switching device.

7. A control apparatus (1300, 1400) for a switching apparatus to reduce output distortion while reducing a loss, wherein the switching apparatus comprises at least two switching devices connected in parallel, and a minimum pulse width limit of a first switching device of the at least two switching devices is less than a minimum pulse width limit of a second switching device of the at least two switching devices; and the apparatus (1300, 1400) comprises:

   an obtaining module (1301), configured to obtain an on-state holding time of the switching apparatus; and
   a control module (1302), configured to: control, when the on-state holding time is less than the minimum pulse width limit of the first switching device, the at least two switching devices to remain in a cut-off state; control, when the on-state holding time is greater than or equal to the minimum pulse width limit of the first switching device, the first switching device to perform a switching operation; control, when the on-state holding time is less than the minimum pulse width limit of the second switching device, the second switching device to remain in a cut-off state; and control, when the on-state holding time is greater than or equal to the minimum pulse width limit of the second switching device, the first switching device and the second switching device to perform switching operations.

8. The apparatus (1300, 1400) according to claim 7, wherein
the control module (1302) is configured to generate a first control signal of the first switching device and a second control signal of the second switching device, wherein when the first switching device and the second switching device are turned on, a time point at which the first control signal flips is not later than a time point at which the second control signal flips.

9. The apparatus (1300, 1400) according to claim 7, wherein
the control module (1302) is configured to generate a first control signal of the first switching device and a second control signal of the second switching device, wherein when the first switching device and the second switching device are turned off, a time point at which the first control signal flips is later than a time point at which the second control signal flips.

10. The apparatus (1300, 1400) according to any one of claims 7 to 9, wherein a material of the first switching device is a wide-bandgap semiconductor material, and a material of the second switching device is a silicon material.

11. The apparatus (1300, 1400) according to any one of claims 7 to 10, wherein both the at least two switching devices are power semiconductor devices.

12. The apparatus (1300, 1400) according to any one of claims 7 to 11, wherein the minimum pulse width limit of the first switching device is determined based on a turn-on time of the first switching device and/or a turn-off time of the first switching device.

13. A switchgear, wherein the switchgear comprises a switching apparatus and the control apparatus (1300, 1400) for a switching apparatus according to any one of claims 7 to 12.

14. A computer storage medium, wherein the computer storage medium stores computer instructions, and when the computer instructions are run on an electronic device, the electronic device is enabled to perform the method according to any one of claims 1 to 6.

15. A chip system, wherein the chip system comprises at least one processor, and when program instructions are executed in the at least one processor, the chip system is enabled to perform the method according to any one of claims 1 to 6.

**Patentansprüche**

1.  Steuerverfahren für eine Schalteinrichtung zum Verringern der Ausgangsverzerrung bei gleichzeitiger Reduzierung von Verlusten, wobei die Schalteinrichtung wenigstens zwei parallel geschaltete Schaltvorrichtungen umfasst und unter den wenigstens zwei Schaltvorrichtungen eine minimale Pulsbreitengrenze einer ersten Schaltvorrichtung kleiner ist als eine minimale Pulsbreitengrenze einer zweiten Schaltvorrichtung und die erste Schaltvorrichtung und die zweite Schaltvorrichtung sich in einem Auszustand befinden; und
das Verfahren umfasst:

    Erhalten (S601) einer Einzustand-Haltezeit der Schalteinrichtung;
    Steuern (S602), wenn die Einzustand-Haltezeit kleiner als die minimale Pulsbreitengrenze der ersten Schaltvorrichtung ist, der wenigstens zwei Schaltvorrichtungen derart, dass sie in einem Auszustand bleiben;
    Steuern (S602), wenn die Einzustand-Haltezeit größer oder gleich der minimalen Pulsbreitengrenze der ersten Schaltvorrichtung ist, der ersten Schaltvorrichtung derart, dass sie eine Schaltoperation durchführt;
    Steuern, wenn die Einzustand-Haltezeit kleiner als die minimale Pulsbreitengrenze der zweiten Schaltvorrichtung ist, der zweiten Schaltvorrichtung derart, dass sie in einem Auszustand bleibt; und
    Steuern, wenn die Einzustand-Haltezeit größer oder gleich der minimalen Pulsbreitengrenze der zweiten Schaltvorrichtung ist, der ersten Schaltvorrichtung und der zweiten Schaltvorrichtung derart, dass sie Schaltoperationen durchführen.

2.  Verfahren gemäß Anspruch 1, wobei das Steuern, wenn die Einzustand-Haltezeit größer oder gleich der minimalen Pulsbreitengrenze der zweiten Schaltvorrichtung ist, der ersten Schaltvorrichtung und der zweiten Schaltvorrichtung derart, dass sie Schaltoperationen durchführen, umfasst:
Erzeugen eines ersten Steuersignals der ersten Schaltvorrichtung und eines zweiten Steuersignals der zweiten Schaltvorrichtung, wobei, wenn die erste Schaltvorrichtung und die zweite Schaltvorrichtung eingeschaltet werden, ein Zeitpunkt, an dem das erste Steuersignal umspringt, nicht später ist als ein Zeitpunkt, an dem das zweite Steuersignal umspringt.

3.  Verfahren gemäß Anspruch 1, wobei das Steuern, wenn die Einzustand-Haltezeit größer oder gleich der minimalen Pulsbreitengrenze der zweiten Schaltvorrichtung ist, der ersten Schaltvorrichtung und der zweiten Schaltvorrichtung derart, dass sie Schaltoperationen durchführen, umfasst:
Erzeugen eines ersten Steuersignals der ersten Schaltvorrichtung und eines zweiten Steuersignals der zweiten Schaltvorrichtung, wobei, wenn die erste Schaltvorrichtung und die zweite Schaltvorrichtung ausgeschaltet werden, ein Zeitpunkt, an dem das erste Steuersignal umspringt, später ist als ein Zeitpunkt, an dem das zweite Steuersignal umspringt.

4.  Verfahren gemäß einem der Ansprüche 1 bis 3, wobei ein Material der ersten Schaltvorrichtung ein Halbleitermaterial mit breiter Bandlücke ist und ein Material der zweiten Schaltvorrichtung ein Siliziummaterial ist.

5.  Verfahren gemäß einem der Ansprüche 1 bis 4, wobei die wenigstens zwei Schaltvorrichtungen beide Leistungshalbleitervorrichtungen sind.

6.  Verfahren gemäß einem der Ansprüche 1 bis 5, wobei die minimale Pulsbreitengrenze der ersten Schaltvorrichtung basierend auf einer Einschaltzeit der ersten Schaltvorrichtung und/oder einer Ausschaltzeit der ersten Schaltvorrichtung bestimmt wird.

7.  Steuereinrichtung (1300, 1400) für eine Schalteinrichtung zum Verringern der Ausgangsverzerrung bei gleichzeitiger Reduzierung von Verlusten, wobei die Schalteinrichtung wenigstens zwei parallel geschaltete Schaltvorrichtungen umfasst und eine minimale Pulsbreitengrenze einer ersten Schaltvorrichtung der wenigstens zwei Schaltvorrichtungen kleiner ist als eine minimale Pulsbreitengrenze einer zweiten Schaltvorrichtung der wenigstens zwei Schaltvorrichtungen; und
die Einrichtung (1300, 1400) umfasst:

    ein Erhaltemodul (1301), das dafür ausgelegt ist, eine Einzustand-Haltezeit der Schalteinrichtung zu erhalten; und
    ein Steuermodul (1302), das ausgelegt ist zum:
    Steuern, wenn die Einzustand-Haltezeit kleiner als die minimale Pulsbreitengrenze der ersten Schaltvorrichtung ist, der wenigstens zwei Schaltvorrichtungen derart, dass sie in einem Auszustand bleiben;
    Steuern, wenn die Einzustand-Haltezeit größer oder gleich der minimalen Pulsbreitengrenze der ersten Schaltvorrichtung ist, der ersten Schaltvorrichtung derart, dass sie eine Schaltoperation durchführt; Steuern, wenn die Einzustand-Haltezeit kleiner als die minimale Pulsbreitengrenze der zweiten Schaltvorrichtung ist, der zweiten Schaltvorrichtung derart, dass sie in einem Auszustand bleibt; und Steuern, wenn die Einzustand-Haltezeit größer oder gleich der minimalen Pulsbreitengrenze der zweiten Schaltvorrichtung ist, der ersten Schaltvorrichtung und der zweiten Schaltvorrichtung derart, dass sie Schaltoperationen durchführen.

8. Einrichtung (1300, 1400) gemäß Anspruch 7, wobei das Steuermodul (1302) ausgelegt ist zum Erzeugen eines ersten Steuersignals der ersten Schaltvorrichtung und eines zweiten Steuersignals der zweiten Schaltvorrichtung, wobei, wenn die erste Schaltvorrichtung und die zweite Schaltvorrichtung eingeschaltet werden, ein Zeitpunkt, an dem das erste Steuersignal umspringt, nicht später ist als ein Zeitpunkt, an dem das zweite Steuersignal umspringt.

9. Einrichtung (1300, 1400) gemäß Anspruch 7, wobei das Steuermodul (1302) ausgelegt ist zum Erzeugen eines ersten Steuersignals der ersten Schaltvorrichtung und eines zweiten Steuersignals der zweiten Schaltvorrichtung, wobei, wenn die erste Schaltvorrichtung und die zweite Schaltvorrichtung ausgeschaltet werden, ein Zeitpunkt, an dem das erste Steuersignal umspringt, später ist als ein Zeitpunkt, an dem das zweite Steuersignal umspringt.

10. Einrichtung (1300, 1400) gemäß einem der Ansprüche 7 bis 9, wobei ein Material der ersten Schaltvorrichtung ein Halbleitermaterial mit breiter Bandlücke ist und ein Material der zweiten Schaltvorrichtung ein Siliziummaterial ist.

11. Einrichtung (1300, 1400) gemäß einem der Ansprüche 7 bis 10, wobei die wenigstens zwei Schaltvorrichtungen beide Leistungshalbleitervorrichtungen sind.

12. Einrichtung (1300, 1400) gemäß einem der Ansprüche 7 bis 11, wobei die minimale Pulsbreitengrenze der ersten Schaltvorrichtung basierend auf einer Einschaltzeit der ersten Schaltvorrichtung und/oder einer Ausschaltzeit der ersten Schaltvorrichtung bestimmt wird.

13. Schaltgerät, wobei das Schaltgerät eine Schalteinrichtung und die Steuereinrichtung (1300, 1400) für eine Schalteinrichtung gemäß einem der Ansprüche 7 bis 12 umfasst.

14. Computerspeichermedium, wobei das Computerspeichermedium Computeranweisungen speichert, und wenn die Computeranweisungen auf einer elektronischen Vorrichtung ausgeführt werden, die elektronische Vorrichtung befähigt wird, das Verfahren gemäß einem der Ansprüche 1 bis 6 durchzuführen.

15. Chipsystem, wobei das Chipsystem wenigstens einen Prozessor umfasst, und wenn Programmanweisungen in dem wenigstens einen Prozessor ausgeführt werden, das Chipsystem befähigt wird, das Verfahren gemäß einem der Ansprüche 1 bis 6 durchzuführen.

## Revendications

1. Procédé de commande d'un appareil de commutation pour réduire la distorsion de sortie tout en réduisant une perte, l'appareil de commutation comprenant au moins deux dispositifs de commutation connectés en parallèle, et parmi les au moins deux dispositifs de commutation, une limite de largeur d'impulsion minimale d'un premier dispositif de commutation étant inférieure à une limite de largeur d'impulsion minimale d'un deuxième dispositif de commutation, et le premier dispositif de commutation et le deuxième dispositif de commutation étant dans un état de coupure ; et le procédé comprenant :

l'obtention (S601) d'un temps de maintien à l'état passant de l'appareil de commutation ; la commande (S602), lorsque le temps de maintien à l'état passant est inférieur à la limite de largeur d'impulsion minimale du premier dispositif de commutation, aux au moins deux dispositifs de commutation de rester dans un état de coupure :

la commande (S602), lorsque le temps de maintien à l'état passant est supérieur ou égal à la limite de largeur d'impulsion minimale du premier dispositif de commutation, au premier dispositif de commutation de réaliser une opération de commutation ; la commande, lorsque le temps de maintien à l'état passant est inférieur à la limite de largeur d'impulsion minimale du deuxième dispositif de commutation, au deuxième dispositif de commutation de rester dans un état de coupure ; et la commande, lorsque le temps de maintien à l'état passant est supérieur ou égal à la limite de largeur d'impulsion minimale du deuxième dispositif de commutation, au premier dispositif de commutation et au deuxième dispositif de commutation de réaliser des opérations de commutation.

2. Procédé selon la revendication 1, la commande, lorsque le temps de maintien à l'état passant est supérieur ou égal à la limite de largeur d'impulsion minimale du deuxième dispositif de commutation, au premier dispositif de commutation et au deuxième dispositif de commutation de réaliser des opérations de commutation comprenant : la génération d'un premier signal de commande du premier dispositif de commutation et d'un deuxième signal de commande du deuxième dispositif de commutation, lorsque le premier dispositif de commutation et le deuxième dispositif de commutation sont allumés, un point temporel auquel le premier signal de commande bascule n'étant pas postérieur à un point temporel auquel le deuxième signal de commande bascule.

3. Procédé selon la revendication 1, la commande, lorsque le temps de maintien à l'état passant est supérieur ou égal à la limite de largeur d'impulsion minimale du deuxième dispositif de commutation, au premier dispositif de commutation et au deuxième dispositif de commutation de réaliser des opérations de commutation comprenant :
la génération d'un premier signal de commande du premier dispositif de commutation et d'un deuxième signal de commande du deuxième dispositif de commutation, lorsque le premier dispositif de commutation et le deuxième dispositif de commutation sont éteints, un point temporel auquel le premier signal de commande bascule étant postérieur à un point temporel auquel le deuxième signal de commande bascule.

4. Procédé selon l'une quelconque des revendications 1 à 3, un matériau du premier dispositif de commutation étant un matériau semi-conducteur à large bande interdite, et un matériau du deuxième dispositif de commutation étant un matériau de silicium.

5. Procédé selon l'une quelconque des revendications 1 à 4, les au moins deux dispositifs de commutation étant des dispositifs semi-conducteurs de puissance.

6. Procédé selon l'une quelconque des revendications 1 à 5, la limite de largeur d'impulsion minimale du premier dispositif de commutation étant déterminée sur la base d'un temps d'allumage du premier dispositif de commutation et/ou d'un temps d'extinction du premier dispositif de commutation.

7. Appareil de commande (1300, 1400) pour un appareil de commutation destiné à réduire la distorsion de sortie tout en réduisant une perte, l'appareil de commutation comprenant au moins deux dispositifs de commutation connectés en parallèle, et une limite de largeur d'impulsion minimale d'un premier dispositif de commutation des au moins deux dispositifs de commutation étant inférieure à une limite de largeur d'impulsion minimale d'un deuxième dispositif de commutation des au moins deux dispositifs de commutation ; et
l'appareil (1300, 1400) comprenant :

un module d'obtention (1301), configuré pour obtenir un temps de maintien à l'état passant de l'appareil de commutation ; et
un module de commande (1302), configuré pour : commander, lorsque le temps de maintien à l'état passant est inférieur à la limite de largeur d'impulsion minimale du premier dispositif de commutation, aux au moins deux dispositifs de commutation de rester dans un état de coupure ; commander, lorsque le temps de maintien à l'état passant est supérieur ou égal à la limite de largeur d'impulsion minimale du premier dispositif de commutation, au premier dispositif de commutation de réaliser une opération de commutation ; commander, lorsque le temps de maintien à l'état passant est inférieur à la limite de largeur d'impulsion minimale du deuxième dispositif de commutation, au deuxième dispositif de commutation de rester dans un état de coupure ; et commander, lorsque le temps de maintien à l'état passant est supérieur ou égal à la limite de largeur d'impulsion minimale du deuxième dispositif de commutation, au premier dispositif de commutation et au deuxième dispositif de commutation de réaliser des opérations de commutation.

8. Appareil (1300, 1400) selon la revendication 7, le module de commande (1302) étant configuré pour générer un premier signal de commande du premier dispositif de commutation et un deuxième signal de commande du deuxième dispositif de commutation, lorsque le premier dispositif de commutation et le deuxième dispositif de commutation sont allumés, un point temporel auquel le premier signal de commande bascule n'étant pas postérieur à un point temporel auquel le deuxième signal de commande bascule.

9. Appareil (1300, 1400) selon la revendication 7, le module de commande (1302) étant configuré pour générer un premier signal de commande du premier dispositif de commutation et un deuxième signal de commande du deuxième dispositif de commutation, lorsque le premier dispositif de commutation et le deuxième dispositif de commutation sont éteints, un point temporel auquel le premier signal de commande bascule étant postérieur à un point temporel auquel le deuxième signal de commande bascule.

10. Appareil (1300, 1400) selon l'une quelconque des revendications 7 à 9, un matériau du premier dispositif de commutation étant un matériau semi-conducteur à large bande interdite, et un matériau du deuxième dispositif de commutation étant un matériau de silicium.

11. Appareil (1300, 1400) selon l'une quelconque des revendications 7 à 10, les au moins deux dispositifs de commutation étant des dispositifs semi-conducteurs de puissance.

**12.** Appareil (1300, 1400) selon l'une quelconque des revendications 7 à 11, la limite de largeur d'impulsion minimale du premier dispositif de commutation étant déterminée sur la base d'un temps d'allumage du premier dispositif de commutation et/ou d'un temps d'extinction du premier dispositif de commutation.

**13.** Appareil de commutation, l'appareil de commutation comprenant un appareil de commutation et l'appareil de commande (1300, 1400) pour un appareil de commutation selon l'une quelconque des revendications 7 à 12.

**14.** Support de stockage informatique, le support de stockage informatique stockant des instructions informatiques, et lorsque les instructions informatiques sont exécutées sur un dispositif électronique, le dispositif électronique est en mesure de réaliser le procédé selon l'une quelconque des revendications 1 à 6.

**15.** Système de puce, le système de puce comprenant au moins un processeur, et lorsque les instructions de programme sont exécutées dans l'au moins un processeur, le système de puce est en mesure de réaliser le procédé selon l'une quelconque des revendications 1 à 6.

FIG. 1

FIG. 2

FIG. 3

IGBT        MOSFET

FIG. 4

IGBT
driver

MOSFET
driver

Time

Vh

Time

Id

Time

Ic

Time

51 52  53 54    55 56 57 58

FIG. 5

S601

Obtain an on-state holding time of a switching apparatus

S602

When the on-state holding time is less than a minimum pulse width limit of the first switching device, control the at least two switching devices to remain a cut-off state; and when the on-state holding time is greater than or equal to the minimum pulse width limit of the first switching device, control the first switching device to perform a switching operation

## FIG. 6

Obtain an on-state time T    S701

$T_{on} < T_{mpw1}$    S702

No

Yes

$T_{on} < T_{mpw2}$    S703

Yes    No

First switching mode | Second switching mode | Third switching mode    S704

Control signal

## FIG. 7

First control signal

Second control signal

First switching mode | Second switching mode | Third switching mode

$\Delta t$off

FIG. 8

First control signal

Second control signal

First switching mode | Second switching mode | Third switching mode

$\Delta t$on | $\Delta t$off

FIG. 9

1200

1210

Processing unit 1211 → Electrical isolation unit 1212

Drive unit 1213

1220

1222

1221

Vge | Vgs

FIG. 10

1300

Obtaining module — 1301

Control module — 1302

FIG. 11

1400

Memory — 1401

Processor — 1402

FIG. 12

**EP 3 965 297 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201911397900

- US 20130257177 A1